(19) Europäisches Patentamt / European Patent Office / Office européen des brevets

(11) **EP 1 551 100 B1**

(12) **FASCICULE DE BREVET EUROPEEN**

(45) Date de publication et mention
de la délivrance du brevet:
**16.04.2008 Bulletin 2008/16**

(51) Int Cl.:
**H03G 7/06** (2006.01)

(21) Numéro de dépôt: **04368077.6**

(22) Date de dépôt: **28.12.2004**

(54) **Cellule d'atténuation présentant un dispositif de commande du facteur d'atténuation**

Dämpfungseinheit mit einer Vorrichtung zum Steuern des Dämpfungsfaktors

Attenuator comprising a control device for controlling the attenuation factor

(84) Etats contractants désignés:
**AT BE BG CH CY CZ DE DK EE ES FI FR GB GR HU IE IS IT LI LT LU MC NL PL PT RO SE SI SK TR**

(30) Priorité: **29.12.2003 FR 0315479**

(43) Date de publication de la demande:
**06.07.2005 Bulletin 2005/27**

(73) Titulaire: **STMicroelectronics S.A.**
**92120 Montrouge (FR)**

(72) Inventeurs:
• **Grasset, Jean-Charles**
**38430 Moirans (FR)**
• **Bossu, Frédéric**
**CA 92126, San Diego (US)**

(74) Mandataire: **Schuffenecker, Thierry**
**120 Chemin de la Maure**
**06800 Cagnes sur Mer (FR)**

(56) Documents cités:
**US-A- 6 084 471**     **US-A- 6 124 761**

## Description

### Domaine technique de l'invention

La présente invention concerne les circuits analogiques de traitement du signal et notamment une cellule d'atténuation présentant un dispositif de commande du facteur d'atténuation, linéaire en dB en fonction d'une valeur de commande, tension ou courant.

### Etat de la technique

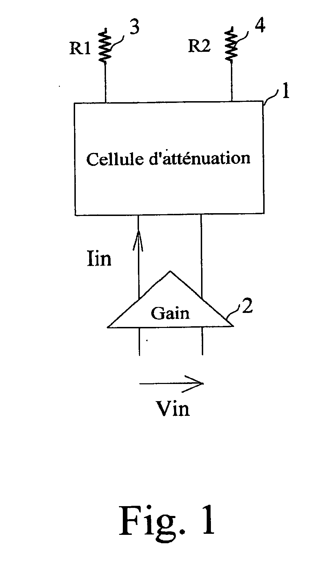

La cellule d'atténuation est fréquemment utilisée dans les circuits analogiques de traitement du signal. Lorsqu'elle est associée à un amplificateur, elle permet de réaliser un gain variable comme cela est illustré dans la figure 1 où l'on voit une cellule 1 combinée à un amplificateur 2 - de type à transconductance - qui reçoit un signal d'entrée différentiel $V_{in}$. En faisant varier le courant circulant dans la charge, composée de deux résistances 3 et 4, on commande le gain de l'ensemble du circuit.

Dans de nombreuses applications il est souhaitable de disposer d'une commande linéaire d'un gain exprimé directement en décibel à partir d'une consigne d'entrée, courant ou potentiel. Dans les techniques de télécommunication sans fil les plus récentes, basées sur le principe du Wideband Code Division Multiple Access (WCDMA) ou encore le *Code Division Multiple Access* (CDMA) on prévoit de commander le gain des circuits internes d'un téléphone mobile communiquant avec une station de base à partir de données de commande provenant de cette même station de base. Les performances du téléphone dépendent directement de la précision avec laquelle on peut commander le gain fixé par la station de base.

Dans les applications de téléphonie sans fil, mais dans également bien d'autres applications, il est souhaitable de réaliser une commande précise du gain des amplificateurs qui est de surcroît indépendante de la température et de la dispersion des caractéristiques résultant du procédé de fabrication. Dans ces conditions, les tâches de calibration sont grandement simplifées ainsi que la mise au point du téléphone.

D'une manière générale, dans les circuits connus, on réalise la relation linéaire entre le gain en décibel et la consigne au moyen d'une approximation de second ordre, ce qui conduit à une précision très limitée. On ne dépasse guère la précision de 1% au moyen de cette technique.

Le brevet américain US 6,084,471 intitulé « *Soft-limiting Control circuit for variable gain amplifier* » de Robert N. Ruth et al. décrit un exemple d'un circuit de commande de gain d'un amplificateur basée sur un mécanisme à la fois analogique et numérique utilisant un processeur de signal (Digital Signal Processor).

Le brevet américain US 6,124,761 intitulé « *variable gain amplifier with gain linear with control voltage"* de Trevor Robinson et al. décrit un autre exemple connu de cellule d'atténuation basée sur l'emploi de diode parcourue par un courant de manière à réaliser une commande linéaire du gain.

On observe que les cellules de contrôle d'atténuation connues sont limitées en ce qui concerne la précision du facteur d'atténuation, laquelle dépend, en outre, grandement de la température du fonctionnement. Il serait souhaitable de pouvoir disposer d'une cellule de contrôle d'atténuation permettant une grande précision et ce pour une large plage de température, supérieure à 100 degrés celsius.

### Résumé de l'invention

La présente invention a pour objet un circuit de contrôle d'atténuation permettant la commande précise d'un gain, exprimé en décibel, à partir d'une consigne - courant ou tension d'entrée.

Ce but est atteint par la cellule d'atténuation selon l'invention qui comporte une première paire différentielle alimentée par une première source de courant ainsi qu'une seconde paire différentielle alimentée par une seconde source de courant. L'entrée de la cellule se compose, d'une part, des émetteurs connectés de façon commune de la première paire et, d'autre part, des émetteurs connectés de façon commune de la seconde paire différentielle.

Un dispositif de commande du gain applique un potentiel VA - VB entre les bases des deux paires différentielles et comporte un jeu de trois diodes dans lesquelles on fait respectivement parcourir un courant IA, IB et la somme IA + IB des deux courants précédents. Les deux diodes parcourues par un courant IB et IA+IB génèrent un potentiel, respectivement VB et VC et la différence entre ces deux potentiels sert à générer une grandeur Iz utilisée dans une boucle d'asservissement. Une consigne Vct est transformée en une information Ix, puis en une information Iy proportionnelle à la température absolue T, et un amplificateur d'erreur utilise l'information Iy - Iz et génère les courants IA et IB en minimisant cette différence.

Plus spécifiquement, le dispositif de commande du gain comporte :

- une première diode dans laquelle circule un courant IA de manière à générer une différence de potentiel commandant ledit potentiel VA ;

- une seconde diode dans laquelle circule un courant IB de manière à générer une différence de potentiel commandant ledit potentiel VB ;

- une troisième diode dans laquelle circule la somme IA + IB des courants circulants dans lesdites premières et seconde diodes généré par une source de courant de manière à générer une différence de potentiel VC correspondant à la somme des courant IA + IB;

- un amplificateur disposant de deux entrées connectées respectivement aux potentiels VB et VC générés par de ladite seconde et la dite troisième diode, ledit amplificateur générant une information Iz représentative de la différence entre les potentiels VB et VC et proportionnelle a l'atténuation en dB;

- un circuit convertisseur recevant une valeur de consigne Vct variant linéairement et générant une première grandeur électrique intermédiaire Ix ;

- un circuit multiplieur recevant ladite première grandeur intermédiaire et générant une seconde grandeur ly proportionnelle à ladite valeur de consigne Vct et à la température absolue T ;

- un amplificateur d'erreur recevant en entrée l'erreur ly - Iz et générant les courants IA et IB de manière à minimiser ladite erreur ;

De préférence, toutes les informations Ix ly et Iz sont des courants différentiels et ledit amplificateur d'erreur est un amplificateur de courant.

Dans un mode de réalisation préféré, on dispose de suiveurs de tension entre les potentiels VA et VB générées par la première et seconde diode, et les bases des deux paires différentielles de la cellule d'atténuation. Ces suiveurs de tension sont indispensables pour assurer une insensibilite au procédé de fabrication du gain en courant des transistors, et pour atteindre de forts niveaux d'atténuation.

**Description des figures**

La figure 1 illustre le schéma classique d'une cellule d'atténuation associée à un circuit amplificateur permettant de réaliser un gain variable.

La figure 2 illustre l'architecture de base d'une cellule d'atténuation à laquelle on appliquera le dispositif de commande du gain selon l'invention.

La figure 3 illustre le mode de réalisation préféré du dispositif de commande du gain selon l'invention.

La figure 4 illustre le mode de réalisation préféré du circuit convertisseur 30 du dispositif de commande de gain selon l'invention.

La figure 5 illustre le mode de réalisation préféré du multiplieur analogique 40 du dispositif de commande de gain selon l'invention.

La figure 6 illustre la caractéristique linéaire obtenue avec la commande de gain de la cellule d'atténuation.

**Description d'un mode de réalisation préféré**

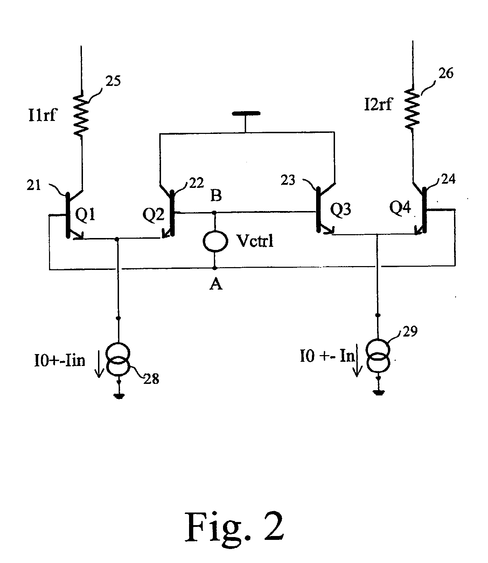

La figure 2 illustre l'architecture de base d'une cellule d'atténuation à laquelle on appliquera la commande de gain conformément à l'invention. Cette cellule se compose de deux paires différentielles de transistors bipolaires. La première paire comporte un premier transistor Q1 21 et un second transistor Q2 22, tandis que la seconde paire se compose d'un troisième transistor Q3 23 et d'un quatrième transistor Q4. L'électrode commune d'émetteur de chacune des paires de transistors Q1-Q2 et Q3-Q4 est polarisée par un courant de polarisation $I_0$ fournie par une source de courant, respectivement 28 et 29.

Les bases des transistors Q1 et Q4 sont connectées ensemble à un même potentiel A et, de même, les bases des transistors Q2 et Q3 sont connectées à un même potentiel B. La différence de potentiel entre les deux points A et B est fixée par une tension de commande $V_{ctrl}$, , laquelle permet de commander l'atténuation appliquée par la cellule d'atténuation composée des deux paires différentielles Q1-Q2 et Q3-Q4. D'une manière générale, la cellule d'atténuation comporte deux électrodes d'entrées, lesquelles se composent, d'une part, de l'électrode commune d'émetteur de la paire Q1-Q2 et, d'autre part, de l'électrode commune d'émetteur commun de la paire Q3-Q4. Les collecteurs de transistors Q1 et Q4 fournissent une première et une seconde électrode de sorties de la cellule d'atténuation, auxquelles on connectera, comme on le voit dans la figure 2, une première charge résistive 25 et une seconde charge résistive 26.

Plus généralement on pourra également envisager des charges de type inductif.

L'application d'une tension différentielle entre les deux bases de la cellule d'atténuation crée une dérivation de courant entre les émetteurs des deux paires différentielles Q1-Q2 et Q3-Q4 comme cela est illustré dans la figure 2 par la source de courant $I_{in}$. Ce courant $I_{in}$ est le courant d'entrée de la cellule d'atténuation provenant, par exemple, d'un amplificateur à transconductance comme celui qui est illustré dans la figure 1. Iin est aiguillé ainsi soit completement dans Q1 (respectivement Q4), soit complètement dans Q2 (respectivement Q3), soit partiellement dans Q1 ou Q2, assurant differents niveaux d'atténuation pour le courant I1rf (respectivement I2rf).

Si l'on désigne par $I_{1rf}$ le courant de collecteur du transistor Q1 circulant dans la première charge résistive 25 et par $I_{2rf}$ le courant de collecteur du transistor Q4 circulant dans la seconde charge résistive 26, on peut écrire la fonction de transfert de la cellule d'atténuation de la figure 2 :

$$\text{Ai (dB)} = 20 \cdot \log ( i_{1rf} / I_{rf} ) \qquad (1)$$

On peut montrer que le facteur d'atténuation de la cellule, que l'on désignera par l'expression générique de gain (même lorsque celui-ci est inférieur à 1) est une grandeur qui est directement homothétique du rapport des courants de polarisation des transistors, ce qui permet d'exprimer le gain en décibel sous la forme suivante :

$$\text{Ai (dB)} = 20 \log ( I_{Q1}/I_0) \qquad (2)$$

Avec $I_{Q1}$ représentant le courant de polarisation du transistor Q1.

On observe donc que si l'on fait passer la totalité du courant $I_0$ dans le transistor Q1 on obtient alors un facteur d'atténuation de 0 dB, par conséquent un gain maximum. Si l'on ne fait passer que la moitié du courant $I_0$ dans le transistor Q1, alors l'atténuation est de -6dB, ce qui correspond à une valeur de 0.5. On voit donc que l'on commande l'atténuation de la cellule d'atténuation en venant fixer précisément le courant de polarisation du transistor Q1 au moyen d'une tension de commande $V_{ctrl}$ dont on va à présent décrire le mode de commande.

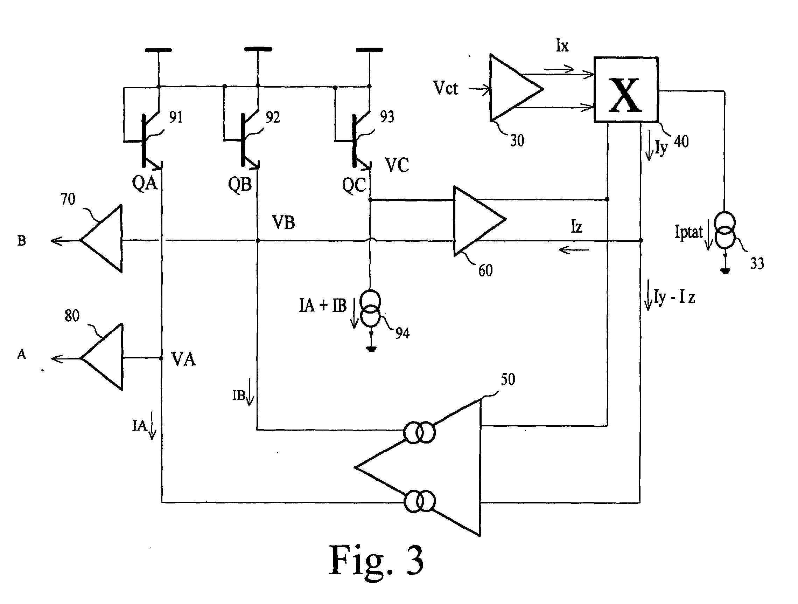

La figure 3 illustre le circuit de commande du facteur d'atténuation de la cellule décrite dans la figure 2, et notamment la génération des potentiels A et B de commande des bases des transistors Q1-Q4 et Q2-Q3.

Le circuit de commande comporte un circuit convertisseur 30 recevant une grandeur analogique de consigne, par exemple une tension ou un courant servant à commander de manière linéaire le facteur d'atténuation de la cellule.

Dans le mode de réalisation préféré, la consigne se présente sous la forme d'un potentiel Vct que le circuit convertisseur 30 convertit sous la forme d'un courant différentiel Ix.

En effet, dans le mode de réalisation préféré, toutes les grandeurs électriques sont converties en un courant différentiel, ce qui permet de simplifier considérablement la conception du circuit d'asservissement et accroît, par ailleurs, la précision de la commande du facteur d'atténuation.

Le courant différentiel Ix généré par le circuit 30 est ensuite transmis à un multiplieur analogique 40, lequel effectue la multiplication du courant Ix généré par l'amplificateur 30 par une grandeur $I_{ptat}/I_0$ proportionnelle à la température (*Proportionnal To Absolute Temperature* PTAT). Il en résulte la génération d'une consigne Iy qui est directement proportionnelle à la température absolue T (en degré Kelvin) et qui sera utilisée dans la boucle d'asservissement du circuit de commande afin d'assurer une insensibilité en température dans une large plage de température de fonctionnement.

En sortie, le multiplieur 40 génère un courant différentiel de consigne Iy qui est proportionnel à la température absolue, suivant la formule :

$$I y = 2 \cdot I x \cdot I_{ptat}/I_0 = 2.Ix/Io.K1.T/Rs$$

K1 : constante de conception
T : température absolue en Kelvin.
Rs : résistance utilisée pour générer le courant Iptat. Cette résistance est, de préférence, une résistance intégrée sur silicium.

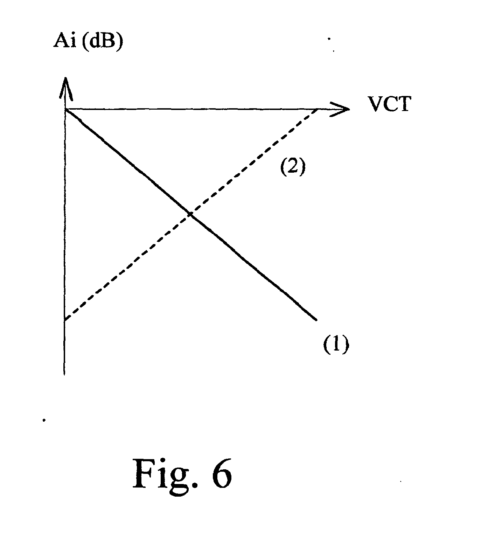

Le circuit comporte par ailleurs un ensemble de trois transistors 91, 92 et 93 qui sont montés en diodes et dont les jonctions n-p sert à générer la conversion linéaire logarithmique permettant la commande linéaire du facteur d'atténuation exprimé en décibel, tel que représentée dans la figure 6.

Un premier transistor 91 , monté en diode, est parcouru par un courant IA et présente une électrode d'émetteur dont le potentiel VA est transmis, via un suiveur de tension 80, au potentiel A de commande des bases communes des transistors Q1-Q4 de la figure 2.

Un second transistor 92, monté aussi en diode, est parcouru par un courant IB et présente une électrode d'émetteur dont le potentiel VB est transmis, via suiveur de tension 70, au potentiel B des bases communes des transistors Q2-Q3 de la figure 2.

Les éléments 70 et 80 servent à assurer que les bases des transistors Q2-Q3 et Q1-Q4, respectivement, ne viennent pas perturber la précision du mécanisme d'asservissement de la figure 3. Ceci permet de controler de forts niveaux d'attenuations.

D'une manière avantageuse, on dispose enfin un troisième transistor bipolaire QC 93, lui également monté en diode, et dans lequel on fait parcourir la somme des deux courants IA + IB , générée par une source de courant 94. L'électrode d'émetteur de ce transistor 93 génère un potentiel VC qui est transmis à une première entrée d'un circuit amplificateur 60 dont une seconde entrée reçoit le potentiel d'émetteur du transistor QB 92. En considérant ainsi la boucle translineaire constituée des transistors 91 et 92 de la figure 3, et des transistors Q1-Q2 de la figure 2, on peut facilement demontrer que :

$$\text{Ai (dB)} = 20 \cdot \log ( i_{1rf} / I_{rf} ) = 20 \cdot \log ( IB/ (IA + IB))$$

La différence de potentiel VB - VC est ainsi directement transmise à l'amplificateur 60, fortement degenere pour assurer une bonne linéarité, et les potentiels d'émetteur des transistors 91 et 93 sont ainsi utilisés dans la boucle d'asservissement du circuit de commande de gain. En effet, l'amplificateur 60 reçoit ces deux potentiels à ses deux entrées et génère à partir de la ddp entre les points B et C un courant différentiel Iz , lequel, comme on le voit sur la figure 3, se retrouve soustrait au courant différentiel de consigne Iy généré par le multiplieur 40.

Iz est une grandeur proportionnelle a la valeur en dB de l'attenuation et peut être exprimée de la facon suivante :

Iz=T.$\alpha$.AidB/Rampli

T : température absolue en Kelvin

$\alpha$ : constante de conception, indépendante de la température et du procédé de fabrication

Rampli : valeur de la résistance de degenerescence de l'amplificateur 60.

Iy, comme on le verra plus particulièrement dans la suite, peut être exprimé comme :

$$\text{Iy} = 2.I1.VCT/Vo.Ro/Rp = 2.K1.T/Rs.VCT/Vo.Ro/Rp$$

Afin d'avoir également de la flexbilite dans le contrôle du gain, on ajoute ou on soustrait généralement un courant Ioffset a Iy. Ce courant Ioffset est également PTAT et peut être exprimé par :

$$\text{Ioffset} = K2.T \ / \ Roffset$$

Avec:

K2 : constante de conception

T : température absolue en Kelvin

Roffset : résistance intégrée sur silicium

La différence Iy - Iz est ensuite utilisée comme une grandeur d'erreur qui est transmise à un amplificateur d'erreur 50, lequel génère les courant IA et IB de manière à réduire à zéro la grandeur Iy - Iz. Dans un mode de réalisation préféré, l'amplificateur d'erreur 50 génère les courant IA , IB et également le courant IA + IB qui circule dans le troisième transistor 93.

On obtient ainsi une boucle de commande différentielle du facteur d'atténuation de la cellule d'atténuation. Aucune approximation mathématique n'est réalisée et l'on constate que la boucle de commande assure une grande précision de la commande du gain. L'asservissement réalisé par l'amplificateur d'erreur 50 permet de compenser précisément les phénomènes de dépendance de la température des jonctions des diodes 91-93.

Il en résulte une commande linéaire du facteur d'atténuation de la cellule d'atténuation, exprimé en décibel, laquelle commande est très largement indépendante de la température et de la dispersion des caractéristiques, comme on le voit sur la formule :

$$\text{Ai (dB)} = 2.\text{K1}/\alpha.\text{Rampli}/\text{Rs}.\text{VCT}/\text{Vo}.\text{Ro}/\text{Rp} \pm 2.\text{K2}/\alpha.\text{Rampli}/\text{Roffset} \quad (3)$$

Grâce à l'asservissement qui a été réalisé, on obtient une expression du gain Ai (dB) qui ne dépend plus de la température, mais uniquement du rapport de grandeurs de même nature, ce qui assure une excellente précision en fonction du procédé de fabrication et de la température. L'atténuation est commandée par une équation du premier degré, dont on peut facilement commander la pente (en fontion de VCT), mais aussi l'ordonnée a l'origine, grâce au courant de contrôle Ioffset.

L'insensibilité à la température qui est obtenue grâce à la génération d'une consigne proportionnelle à la température absolue permet d'atteindre une précision supérieure à 1dB pour une plage de température variant de 125 degrés.

L'utilisation du courant pour réaliser les asservissements permet d'atteindre une meilleure précision de réalisation, puisque le montage sera tres peu sensible aux chutes de potentiels dues a des résistances parasites de routage sur silicium.

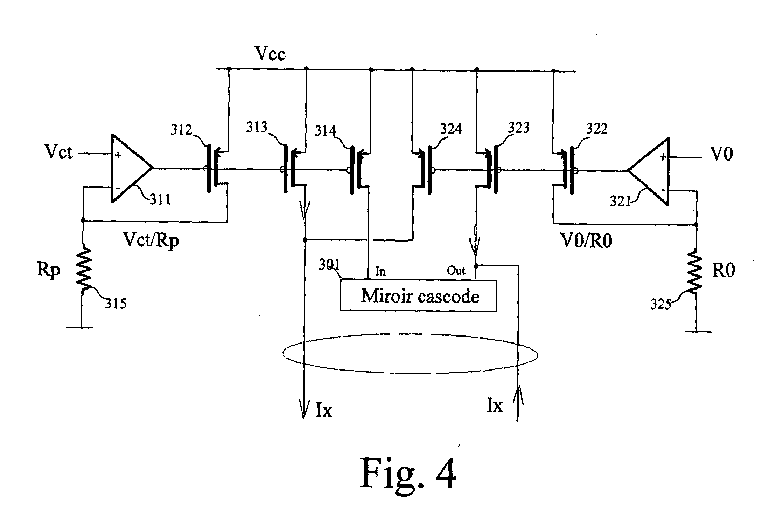

La figure 4 illustre le mode de réalisation préféré du circuit convertisseur tension-courant 30. Celui-ci comporte deux amplificateurs 311 et 321 présentant chacun une entrée non inverseuse connectée respectivement à une tension de consigne $V_{ct}$ et une tension de référence $V_0$. Les amplificateurs 311 et 321 présentent chacun une entrée inverseuse qui est connectée à la masse via une résistance Rp et R0 respectivement. Ils comportent en outre chacun une électrode de sortie, laquelle est connectée à la grille d'un ensemble de trois transistors MOS, 312-313-314 et 324-323-322 respectivement. L'électrode de source de tous les transistors est connectée au potentiel positif Vcc.

Le transistor 312 (resp. 322) dispose d'un drain qui est connecté à l'entrée inverseuse de l'amplificateur 311 (resp. 321). Le drain du transistor 313 est connecté au drain du transistor 324 et également à une première électrode de sortie du circuit convertisseur 30. Le drain du transistor 314 est connecté à une entrée d'un circuit miroir cascode 301 , dont une sortie est connecté au drain du transistor 323 et également à une seconde électrode de sortie du circuit convertisseur 30.

Le fonctionnement du circuit 30 est le suivant : la combinaison du transistor MOS 312 et de l'amplificateur 311 permet de générer un courant $V_{ct}/R_p$ qui circule dans le transistor 313 (monté en miroir de courant par rapport au transistor 312).

De la même manière, la combinaison du transistor MOS 322 et de l'amplificateur 321 engendre un courant $V_0/R_0$ circulant dans le transistor 323. Le transistor 324, monté en miroir de courant également, permet de générer une réplique de ce courant V0/R0 qui vient s'additionner au courant $V_{ct}/R_p$.

Les deux électrodes de sorties du circuit 30 voient donc circuler un courant $V_0/R_0 + V_{ct}/R_p$ et $V_0/R_0 - V_{ct}/R_p$ respectivement.

On réalise ainsi la conversion de courant différentielle. Il faut observer que la génération des courants doit être réalisée avec une grande précision. A cet effet, les résistances présenteront des valeurs précises et les transistors MOS seront de préférence des transistors à grande surface afin de réduire les tensions de décalage (Offset). De la même manière on réduira la tension de décalage (offset) des amplificateur 311 et 321. Enfin, pour la tension V0, on choisira un potentiel de référence indépendant de la température, ce qui pourra être réalisé au moyen d'une référence de type Bande Gap.

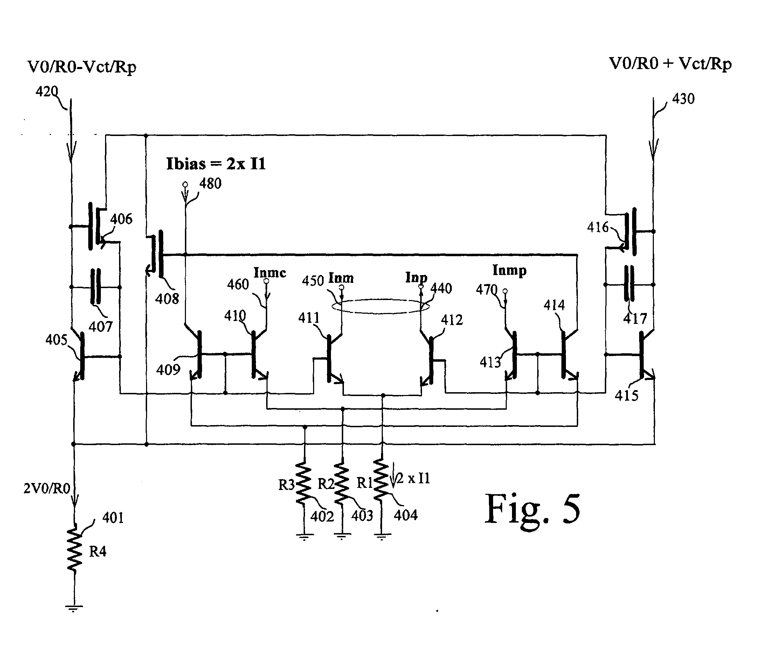

La figure 5 illustre le mode de réalisation préféré du multiplieur analogique 40.

Le multiplieur comporte deux transistors d'entrées 415 et 405 dont l'électrode de collecteur reçoit respectivement les courants $V_0/R_0 + V_{ct}/R_p$ et $V_0/R_0 - V_{ct}/R_p$ générés en sortie du convertisseur 30. L'électrode d'émetteur des deux transistors 415 et 405 est connectée via une résistance R4 401 à la masse.

Le multiplieur 40 comporte en outre deux transistors de sorties 411 et 412 parcourus respectivement par un courant Inm et Inp qui est transmis via le collecteur à l'une des électrodes de sortie du multiplieur, respectivement 450 et 440. L'émetteur de chacun des transistors 411 et 412 est connecté à une résistance R1 404 dont l'autre électrode est connectée à la masse.

Le multiplieur comporte en outre deux transistors 410 et 413 parcourus par un courant de recopie Inmc et Inmp, respectivement, et qui présentent une électrode d'émetteur commune connectée la masse via une même résistance R2 403.

Deux transistors MOS de type buffer 406 et 416 présentent une grille connectée respectivement à l'électrode 420 et 430 et voient leurs électrodes de drain connectées ensemble. La source du transistor 406 est connectée aux bases des transistors 405, 409, 410 et 411 tandis que la source du transistor 416 est connectée aux bases des transistors 412, 413, 414 et 415. Deux condensateurs 407 et 417, respectivement connectés entre grille et source des transistors 406 et 407 sont utilisés pour stabiliser le fonctionnement de ces mêmes transistors.

Un transistor MOS 408 présente une grille connectée à l'électrode 480 recevant un courant de référence Ibias, et un drain connecté aux drains communs des transistors 406 et 417. Sa source est connectée a la résistance 401.

L'ensemble des transistors 408, 409, 414 et 402 assure la polarisation de tous les transistors 405, 410, 411, 412, 413 et 415 en autorisant une faible tension sur les émetteurs des transistors 405, 409, 410, 411, 412, 413 , 414 et 417, typiquement 100 mV. Si l'on avait une source de courant en place des transistors 402, 403 et 304, il aurait fallu avoir environ 400mV minimum. Comme on le voit ce circuit permet de réaliser un empilement, sous faible voltage (2.5 Volt minimum) de la fonction 50 au dessus de la fonction 40.

Le fonctionnement du multiplieur analogique 40 est le suivant :

Si l'on considère la boucle translinéaire constituée de 405-411-412-415, on peut écrire que :

$$(Vo/Ro - VCT/Rp).Inp = (Vo/Ro + VCT/Rp).Inm$$

En développant, on obtient :

$$I_{nm} = I_1 . (1 - x\, Ro/Rp)$$

et

$$I_{np} = I_1 . ( 1 + x. Ro/Rp)$$

Avec $x = V_{ct}/V_0$.

Comme $Iy = Inp - Inm$, on obtient : $Iy = 2.I1.VCT/Rp.Ro/Vo$

La résistance R1 404 est parcourue par un courant que l'on posera égal à $2x\, I_1$

$I_1$ est un courant PTAT réalise par un circuit conventionnel. On constate donc que l'on peut transformer la donnée absolue Vct/V0 en une grandeur qui est ptat $I_1$.

En sortie du multiplieur analogique 40 , on obtient ainsi un courant différentiel Iy = Inp - Inm qui est directement proportionnel à la température absolue T.

Ce courant peut alors être directement utilisé dans la boucle de contre-réaction de la figure 3 pour générer l'erreur Iy - Iz utilisée par l'amplificateur d'erreur 50.

Dans un mode de réalisation préféré, l'amplificateur d'erreur 50 est utilisé pour générer les courant IA, IB et IA + IB qui circulent dans les diodes 91, 92 et 93.

## Revendications

1. Cellule d'atténuation présentant un dispositif de commande du facteur d'atténuation ladite cellule comportant:
   une première et une seconde électrodes (A, B) d'entrée et une première et une seconde électrodes de sortie;

   - une première paire différentielle comportant un premier transistor bipolaire (21) et un second transistor bipolaire (22), lesdits premier et second transistors présentant chacun une électrode d'émetteur connectée à une même première source de courant (28) ainsi qu'à la dite première électrode d'entrée, ledit premier transistor (21) présentant un collecteur connecté à ladite première électrode de sortie;
   - une seconde paire différentielle comportant un troisième transistor bipolaire (23) et quatrième transistor bipolaire (24), lesdits troisième et quatrième transistors bipolaires présentant chacun une électrode d'émetteur connectée à une seconde source de courant (29) ainsi qu'à ladite seconde électrode d'entrée, ledit quatrième transistor (24) présentant un collecteur connecté à ladite seconde électrode de sortie ;

   lesdits premier et quatrième transistors bipolaires (21, 24) présentant une base qui est connecté à un même potentiel VA et lesdits second et troisième transistors bipolaires (22, 23) présentant une base connectée à un même potentiel VB ;
le dispositif de commande du facteur d'atténuation fixant respectivement les potentiels VA et VB comportant :

- une première diode (91) dans laquelle circule un courant IA de manière à générer une différence de potentiel commandant ledit potentiel VA ;
- une seconde diode (92) dans laquelle circule un courant IB de manière à générer une différence de potentiel commandant ledit potentiel VB ;

**caractérisé en ce qu**'il comporte en outre:

- une troisième diode (93) dans laquelle circule la somme IA + IB des courants circulants dans lesdites premières et seconde diodes (91, 92) généré par une source de courant de manière à générer une différence de potentiel VC correspondant à la somme des courant IA + IB;
- un amplificateur (60) disposant de deux entrées connectées respectivement aux potentiels VB et VC générés par de ladite seconde (92) et la dite troisième diode (93), ledit amplificateur (60) générant une information Iz représentative de la différence entre les potentiels VB et VC ;
- un circuit convertisseur (30) recevant une valeur de consigne Vct générant une première grandeur électrique intermédiaire Ix;
- un circuit multiplieur (40) recevant ladite première grandeur intermédiaire et recevant une deuxième grandeur électrique proportionelle à la témpérature absolue, ledit circuit multiplieur générant une seconde grandeur Iy proportionnelle à ladite valeur de consigne Vct et à la température absolue T ;
- un amplificateur d'erreur recevant en entrée l'erreur Iy - Iz et générant les courants IA et IB de manière à minimiser ladite erreur.

2. Cellule d'atténuation selon la revendication 1 **caractérisé en ce que** lesdites premières et seconde grandeur (Ix, Iy) et ladite information Iz générée par l'amplificateur recevant lesdits potentiels VB et VC sont des courants, ledit amplificateur d'erreur (50) étant un amplificateur de courant.

3. Cellule d'atténuation selon la revendication 2 **caractérisé en ce qu**'il comporte des suiveurs de tension (70, 80) permettant de respectivement transmettre les potentiels VA et VB aux bases de commande des transistors (21, 22, 23, 24) de ladite cellule d'atténuation.

4. Cellule d'atténuation selon la revendication 2 **caractérisé en ce que** le circuit convertisseur (30) comporte :

- un premier amplificateur et un second amplificateur (311, 312) présentant chacun une entrée non inverseuse, une entrée inverseuse et une sortie,

- ladite entrée non inverseuse du premier et du second amplificateur (311, 312) étant respectivement connectée à une tension de $V_{ct}$ et à une tension de référence $V_0$,
- ladite entrée inverseuse du premier et second amplificateur (311, 312) étant respectivement connectée à la masse via une résistance Rp et R0,

- un premier transistor MOS (312) présentant une électrode de grille, de source et de drain, ladite électrode de source étant connectée au potentiel positif Vcc, ladite électrode de grille étant connectée à la sortie dudit premier amplificateur 311 et ladite électrode de drain étant connectée à l'entrée non inverseuse dudit premier amplificateur 311 ;
- un second transistor MOS (313) présentant une électrode de grille, de source et de drain, ladite électrode de source étant connectée au potentiel positif Vcc, ladite électrode de grille étant connectée à la sortie dudit premier amplificateur 311 et ladite électrode de drain étant connectée à une première sortie du circuit convertisseur 30 ;
- un troisième transistor MOS (314) présentant une électrode de grille, de source et de drain, ladite électrode de source étant connectée au potentiel positif Vcc, ladite électrode de grille étant connectée à la sortie dudit premier amplificateur 311 et ladite électrode de drain étant connectée à une entrée d'un circuit miroir cascode 301 ;
- un quatrième transistor MOS (322) présentant une électrode de grille, de source et de drain, ladite électrode de source étant connectée au potentiel positif Vcc, ladite électrode de grille étant connectée à la sortie dudit second amplificateur 321 et ladite électrode de drain étant connectée à l'entrée non inverseuse dudit premier amplificateur 321 ;
- un cinquième transistor MOS (323) présentant une électrode de grille, de source et de drain, ladite électrode de source étant connectée au potentiel positif Vcc, ladite électrode de grille étant connectée à la sortie dudit second amplificateur 321 et ladite électrode de drain étant connectée à une sortie dudit circuit miroir cascode 301 ainsi qu'à une seconde sortie du circuit convertisseur 30 ;

- un sixième transistor MOS (314) présentant une électrode de grille, de source et de drain, ladite électrode de source étant connectée au potentiel positif Vcc, ladite électrode de grille étant connectée à la sortie dudit second amplificateur 321 et ladite électrode de drain étant connectée à l'électrode de source dudit second transistor MOS (313)

**Claims**

1.  An attenuation cell having an attenuation factor control device, said cell comprising first and second input electrodes (A, B) and first and second output electrodes;

    - a first differential pair comprising a first bipolar transistor (21) and a second bipolar transistor (22), said first and second transistors each having a transmitter electrode connected to a same first power source (28) and to said first input electrode, said first transistor (21) having a collector connected to said first output electrode;
    - a second differential pair comprising a third bipolar transistor (23) and a fourth bipolar transistor (24), said third and fourth bipolar transistors each having a transmitter electrode connected to a second power source (29) and to said second input electrode, said fourth transistor (24) having a collector connected to said second output electrode;

    said first and fourth bipolar transistors (21, 24) having a base that is connected to the same voltage VA and said second and third bipolar transistors (22, 23) having a base connected to the same voltage VB;
    the attenuation factor control circuit for setting voltages VA and VB respectively, comprising:

    - a first diode (91) seeing a current IA so as to generate a voltage difference controlling said voltage VA;
    - a second diode (92) seeing a current IB so as to generate a voltage difference controlling said voltage VB;

    **characterized in that** it further comprises:

    - a third diode (93) seeing the sum IA + IB of the currents flowing through said first and second diodes (91, 92), said sum being generated by a power source so as to generate a voltage difference VC corresponding to the sum of current IA + IB;
    - an amplifier (60) having two inputs connected to voltages VD and VC generated by said second (92) and said third diode (93) respectively, said amplifier (60) generating information Iz representative of the difference between voltages VB and VC;
    - a converter circuit (30) receiving a desired value Vct generating a first intermediate electric value Ix;
    - a multiplier circuit (40) receiving said first intermediate value and receiving a second electric value proportional to the absolute temperature T and said multiplier circuit generating a second value Iy proportional to said desired value Vct and to absolute temperature T;
    - an error amplifier receiving error Iy -Iz as an input and generating currents IA and IB in order to minimize said error.

2.  An attenuation cell according to claim 1 **characterized in that** said first and second values (Ix, Iy) and said information Iz generated by the amplifier receiving said voltages VB and VC are currents, said error amplifier (50) being a current amplifier.

3.  An attenuation cell according to claim 2 **characterized in that** it comprises voltage followers (70, 80) making it possible to respectively transmit voltages VA and VB to the control bases of transistors (21, 22, 23, 24) of said attenuation cell.

4.  An attenuation cell according to claim 2 **characterized in that** the converter circuit (30) comprises:

    - a first amplifier and a second amplifier (311, 312) each having a non-inverting input, an inverting input and an output,

        - said non inverting inputs of said first and second amplifiers (311, 312) being connected to a voltage Vct and a reference voltage Vo respectively,
- said inverting inputs of said first and second amplifiers (311, 312) being connected to ground via resistors Rp and R0, respectively,

- a first MOS transistor (312) having a gate electrode, a source electrode and a drain electrode, said source electrode being connected to positive voltage Vcc, said gate electrode being connected to the output of said first amplifier (311) and said drain electrode being connected to the non inverting input of said first amplifier (311);
- a second transistor MOS (313) having a gate electrode, a source electrode and a drain electrode, said source electrode being connected to positive voltage Vcc, said gate electrode being connected to the output of said first amplifier (311) and said drain electrode being connected to a first output of converter circuit (30);
- a third MOS transistor (314) having a gate electrode, a source electrode and a drain electrode, said source electrode being connected to positive voltage Vcc, said gate electrode being connected to the output of said first amplifier (311) and said drain electrode being connected to an input of a mirror cascode circuit (301);
- a fourth MOS transistor (322) having a gate electrode of grid, a source electrode and a drain electrode, said source electrode being connected to positive voltage Vcc, said gate electrode being connected to the output of said second amplifier (321) and said drain electrode being connected to the non inverting input of said first amplifier (321);
- a fifth MOS transistor (323) having a gate electrode, a source electrode and a drain electrode, said source electrode being connected to positive voltage Vcc, said gate electrode being connected to the output of said second amplifier (321) and said drain electrode being connected to an output of said cascode mirror circuit 301 and to a second output of converter circuit (30);
- a sixth MOS transistor (314) having a gate electrode, a source electrode and a drain electrode, said source electrode being connected to positive voltage Vcc, said gate electrode being connected to the output of said second amplifier (321) and said drain electrode being connected to the source electrode of said second MOS transistor (313).

**Patentansprüche**

1. Dämpfungsglied mit einer Vorrichtung zur Steuerung des Dämpfungsfaktors, wobei das besagte Dämpfungsglied eine erste und eine zweite Eingangselektrode (A, B) sowie eine erste und eine zweite Ausgangselektrode besitzt,

- wobei ein erstes Differentialpaar einen ersten bipolaren Transistor (21) und einen zweiten bipolaren Transistor (22) besitzt, wobei der erste und zweite bipolare Transistor jeweils eine Emitterelektrode besitzen, die an ein und dieselbe erste Stromquelle (28) sowie an die besagte erste Eingangselektrode angeschlossen sind, wobei der besagte erste Transistor (21) einen Kollektor besitzt, der an die besagte erste Ausgangselektrode angeschlossen ist,
- wobei ein zweites Differentialpaar einen dritten bipolaren Transistor (23) und einen vierten bipolaren Transistor (24) besitzt, wobei der dritte und vierte bipolare Transistor je eine Sendelektrode besitzen, die an eine zweite Stromquelle (29) sowie an die besagte zweite Eingangselektrode angeschlossen sind, während der besagte vierte Transistor (24) einen Kollektor besitzt, der an die besagte zweite Ausgangselektrode angeschlossen ist,

wobei der erste und der vierte bipolare Transistor (21, 24) eine Basis besitzen, die an ein und dasselbe Potential VA angeschlossen sind, während der zweite und der dritte bipolare Transistor (22, 23) eine Basis besitzen, die an ein und dasselbe Potential VB angeschlossen sind,
wobei die Vorrichtung zur Steuerung des Dämpfungsfaktors, mit dem jeweils die Potentiale VA und VB festgelegt werden,

- eine erste Diode (91) besitzt, in der ein Strom IA so fließt, dass eine Potentialdifferenz gebildet wird, durch die das besagte Potential VA gesteuert wird,
- eine zweite Diode (92) besitzt, in der ein Strom IB so fließt, dass eine Potentialdifferenz gebildet wird, durch die das besagte Potential VB gesteuert wird,

**dadurch gekennzeichnet, dass** es weiterhin

- eine dritte Diode (93) besitzt, in der die Summe IA + IB der in der ersten und zweiten Diode (91, 92) fließenden Ströme fließt, die von einer Stromquelle erzeugt werden, so dass eine Potentialdifferenz VC gebildet wird, die der Summe der Ströme IA + IB entspricht,

- einen Verstärker (60) besitzt, der über zwei Eingänge verfügt, die jeweils an die durch die zweite Diode (92) und die dritte Diode (93) erzeugten Potentiale VR und VC angeschlossen sind, wobei der besagte Verstärker (60) eine Information lz erzeugt, die repräsentativ für die Differenz zwischen den Potentialen VB und VC ist,

- eine Wandlerschaltung (30) besitzt, die einen Vorgabewert Vct aufnimmt, durch den eine erste elektrische Zwischengröße lx erzeugt wird,

- eine Vervielfachungsschaltung (40) besitzt, die die besagte erste Zwischengröße und eine zweite elektrische Größe aufnimmt, die proportional zur absoluten Temperatur ist, während die besagte Vervielfachungsschaltung eine zweite Größe ly erzeugt, die proportional zum besagten Vorgabewert Vct und zur absoluten Temperatur T ist,

- einen Fehlerverstärker besitzt, der am Eingang den Fehler ly - 1z aufnimmt und die Ströme IA und IB so erzeugt, dass der besagte Fehler minimal ist.

2. Dämpfungsglied nach Anspruch 1, **dadurch gekennzeichnet, dass** die erste und die zweite Größe (lx, ly) und die besagte, vom Verstärker erzeugte Information lz, die die besagten Potentiale VR und VC aufnimmt, Stromstärken sind, während der besagte Fehlerverstärker (50) ein Stromverstärker ist.

3. Dämpfungsglied nach Anspruch 2, **dadurch gekennzeichnet, dass** es Spannungsfolger (70, 80) besitzt, mit denen jeweils die Potentiale VA und VB an die Basen zur Steuerung der Transistoren (21, 22, 23, 24) des besagten Dämpfungsglieds übertragen werden.

4. Dämpfungsglied nach Anspruch 2, **dadurch gekennzeichnet, dass** die Wandlerschaltung (30)

- einen ersten und einen zweiten Verstärker (311, 312) besitzt, von denen jeder einen nicht invertierenden Eingang und einen invertierenden Eingang sowie einen Ausgang besitzt,

-- wobei der nicht invertierende Eingang des ersten und des zweiten Verstärkers (311, 312) jeweils an eine Spannung von $V_{ct}$ und an eine Referenzspannung $V_0$ angeschlossen ist,
-- wobei der invertierende Eingang des ersten und des zweiten Verstärkers (311, 312) über die Widerstände Rp und R0 jeweils an die Masse angeschlossen ist,

- einen ersten MOS-Transistor (312) mit einer Gateelektrode, einer Quellenelektrode und einer Drainelektrode besitzt, wobei die besagte Quellenelektrode an das positive Potential Vcc, die besagte Gateelektrode an den Ausgang des besagten ersten Verstärkers 311 und die besagte Drainelektrode an den nicht invertierenden Eingang des besagten ersten Verstärkers 311 angeschlossen ist

- einen zweiten MOS-Transistor (313) mit einer Gateelektronde, einer Quellenelektrode und einer Drainelektrode besitzt, wobei die besagte Quellenelektrode an das positive Potential Vcc, die besagte Gateelektrode an den Ausgang des besagten ersten Verstärkers 311 und die besagte Drainelektrode an einen ersten Ausgang der Wanderschaltung (30) angeschlossen ist,

- einen dritten MOS-Transistor (314) mit einer Gateelektrode, einer Quellenelektrode und einer Drainelektrode besitzt, wobei die besagte Quellenelektrode an das positive Potential Vcc, die besagte Gateelektrode an den Ausgang des besagten ersten Verstärkers 311 und die besagte Drainelektrode an einen Eingang einer Kaskode-Stromspiegelschaltung (301) angeschlossen ist,

- einen vierten MOS-Transistor (322) mit einer Gateelektrode, einer Quellenelektrode und einer Drainelektrode besitzt, wobei die besagte Quellenelektrode an das positive Potential Vcc, die besagte Gateelektrode an den Ausgang des besagten zweiten Verstärkers 321 und die besagte Drainelektrode an den nicht invertierenden Eingang des besagten ersten Verstärkers 321 angeschlossen ist,

- einen fünften MOS-Transistor (323) mit einer Gateelektrode, einer Quellenelektrode und einer Drainelektrode besitzt, wobei die besagte Quellenelektrode an das positive Potential Vcc, die besagte Gateelektrode an den Ausgang des besagten zweiten Verstärkers 321 und die besagte Drainelektrode an einen Ausgang der besagten Kaskodcnschaltung (301) sowie an einen zweiten Ausgang der Wandlerschaltung (30) angeschlossen ist,

- einen sechsten MOS-Transistor (314) mit einer Gateelektrode, einer Quellenelektrode und einer Drainelektrode besitzt, wobei die besagte Ouellenelektrode an das positive Potential Vcc, die besagte Gateelektrode an den Ausgang des besagten zweiten Verstärkers 321 und die besagte Drainelektrode an die Quellenelektrode des besagten zweiten MOS-Transistor (313) angeschlossen ist.

R1 ⌇ 3    R2 ⌇ 4

┌─────────────────────────────┐ 1
│                             │
│   Cellule d'atténuation     │
│                             │
└─────────────────────────────┘

Iin ↑

Gain 2

→
Vin

# Fig. 1

# Fig. 2

Fig. 3

Fig. 4

Fig. 5

EP 1 551 100 B1

Fig. 6

**EP 1 551 100 B1**

## RÉFÉRENCES CITÉES DANS LA DESCRIPTION

**Documents brevets cités dans la description**

- US 6084471 A

- US 6124761 A